# EUROPEAN PATENT SPECIFICATION

(11) **EP 2 534 277 B1**
(45) Date of publication and mention of the grant of the patent: **08.05.2019**
(21) Application number: 11702234.3
(22) Date of filing: 07.02.2011
(51) Int. Cl.: H01J 37/32, H01J 37/34, C23C 14/56

(54) **MODULAR COATER**
MODULARER BESCHICHTER
MACHINE À ENDUIRE MODULAIRE

(30) Priority: 08.02.2010 EP 10152960
(43) Date of publication of application: 19.12.2012
(73) Proprietor: AGC Glass Europe, 1348 Louvain-la-Neuve (BE)
(72) Inventor: WIAME, Hugues, B-6042 Lodelinsart (BE); DEBELLE, Thomas, B-6042 Lodelinsart (BE); BELLET, Philippe, B-5190 Moustier (BE)
(74) Representative: Le Vaguerèse, Sylvain Jacques
(86) International application number: PCT/EP2011/051715
(87) International publication number: WO 2011/095619

(56) References cited:
- EP-A1- 1 826 292
- DE-A1-102008 008 320
- FR-A1- 2 940 321
- US-A1- 2007 256 934

## Description

The present invention concerns a modular vacuum coater apparatus for the deposition of multi-layer coating stacks on glass substrates in an uninterrupted way. This apparatus is a magnetically enhanced sputtering apparatus, also called a magnetron.

Such coatings may comprise one or more, and in particular three or four, most preferably three, silver infrared reflective layers surrounded by dielectric layers, such as metal oxide, metal nitride or metal oxinitride layers. The glass substrate coated with such multi-layer coating can serve to constitute solar control glazing panel or low emissivity glazing panel. The conductivity of the coating can also be used to form a heatable coating for de-icing or de-frosting a vehicle transparency like a windshield or backlite. Other types of coatings may also be formed in this type of modular vacuum coater, such as TCO (Transparent Conductive Oxide) coatings, coloured coatings.

Each layer or group of similar layers (for example metal layers or metal oxide layers or metal nitride layers) of the coating corresponds to a coat zone which comprises one or more positions (a position is a source bay or a sputtering compartment) for cathodes (targets) corresponding to the layer to be deposited and in which a particular atmosphere, containing argon alone or together with oxygen or nitrogen or another specific gas, is maintained in a reduced pressure.

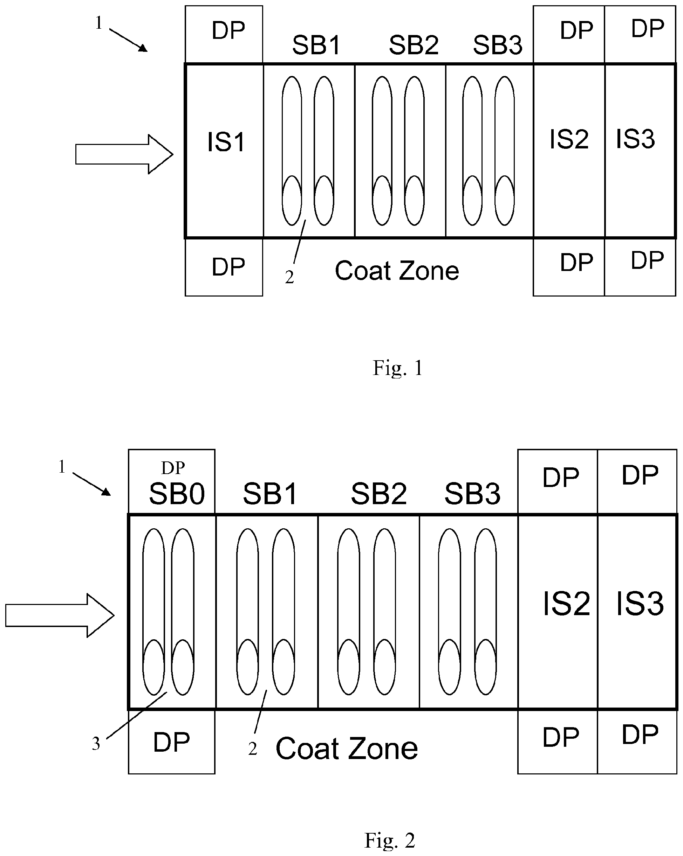

Depending on the design of the coater, one module of a modular coater of the type concerned by the present invention may differ in structure. According to one design, like for example coater sold by Applied Materials Inc., a module may generally comprise a coat zone associated with three pumping zones to maintain the required low level of pressure in the coat zone. This coat zone may generally comprise three (sometimes four) source bays (or sputtering compartments) having target materials to be sputtered (see fig 1).

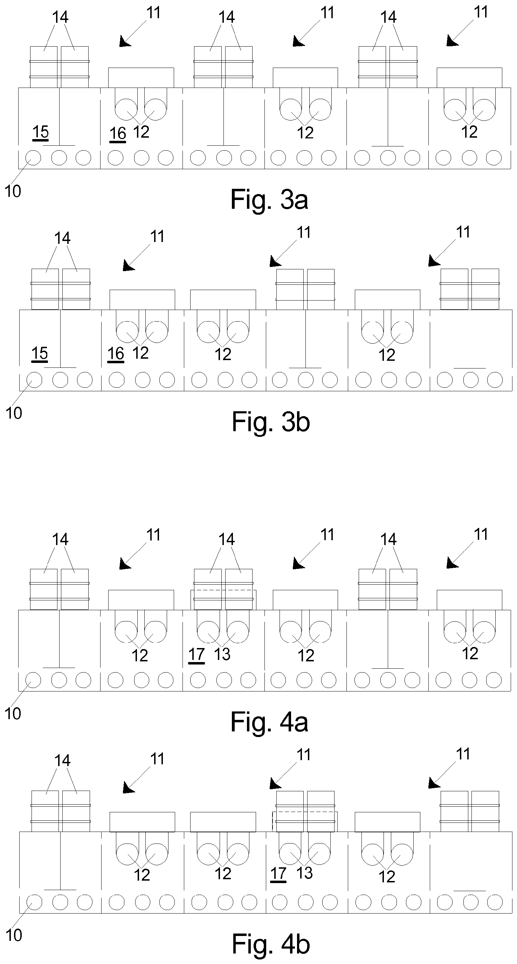

According to another design, like for example coater sold by VON ARDENNE Anlegentechnik GmbH or by Leybold, the module is described as a sputtering compartment (or a source bay) associated with a pumping compartment (or pumping zone) (figure 3a), the coat zone being the sputtering compartment. Depending on the arrangement and since the size of the compartments are the same for sputtering and pumping, two sputtering compartments can be next to each other with the two pumping compartments aside (this arrangement is called mixed cathode/pump arrangement) or in a more standard arrangement each sputtering compartment is separated from the next sputtering compartment by one pumping compartment (fig 3b).

The entire modular coater device comprises several modules one beside the other. In all those arrangements of the modules for the glass industry the coat zones and the pumping zones are always in separated compartments to maintain the required low level of pressure during the process.

US2007/0256934 A1 shows a coating apparatus comprising a number of modules, each of which consists of one or more coating compartments and one or more pumping compartments. EP 1 826 292 A1 shows a module for a coating apparatus which contains both a sputtering target and pumping means.

Due to higher complexity and the increasing number of layers of the new coating stacks, especially for coatings having at least three infrared reflective layers, such as silver layers, the number of required coat zones increases and the existing coating equipments become too small.

Also there is a lack of flexibility of the existing coaters to produce several types of coatings on the same line without venting the line to change the configuration, for example heat treatable and not heat treatable coatings. This increases the number of positions required.

The object of the present invention is to overcome at least some of these drawbacks.

The invention concerns a modular vacuum coater having at least one module comprising at least one coat zone with at least one source bay for a target material and at least one pumping zone with pumping means, characterized in that the pumping zone comprises at least one source bay for a target material so as to use this pumping zone as an additional coat zone.

The invention provides additional coating zones to an existing modular vacuum coater apparatus so that the number of positions for cathodes in an existing coater can be increased. This reduces the time necessary to produce the coating and the coater is more compact for the same throughput. More complex stacks having more layers than before can be produced on the modified coater and the coatings can be produced at higher speed. The invention allows also more flexibility to produce several different coatings on the same coater line without venting the line to change the configuration. A major advantage of the invention is that the transformation of the pumping zone into a sputtering zone can be realised rapidly and specifically where the bottlenecks that limit the production are and is not a drastic and expensive change like increasing the size of the coater production line by adding new modules to that line.

A source (cathode) bearing a target is inserted in the pumping zone. Several types of sputtering sources like a double cathode system such as C-Mag® rotatable cylindrical cathodes, but also planar cathodes or single rotatable cathodes or any other type of sources like PE-CVD, hollow cathodes or ion source can be inserted in the pumping zone. At least one, for example three, turbo molecular pump ("TMP") is associated with and above the cathode bay so as to maintain the required level of low pressure for sputtering process. The existing diffusion pumps, such as 16" diffusion pumps (DP) for the first design type of coater referred to above, of the modified pumping zone may or not be stopped. In the second design type referred to above, extra turbo molecular pumps can be added to the existing pumps in the pumping zone and can be adapted to the cathode lid.

In the present description, the invention is primarily described as a modified existing modular coater. However, it should be understood that the invention can also apply to a new manufactured coater. It is a new concept to design a more compact modular coater providing more coat zones for same space as known coaters and providing more flexibility to produce coatings having a large number of layers and to produce several different coatings on the same coater line without stopping and venting the line to change the configuration.

One or some pumping zones of one or each module of the modular coater may be provided with an additional source bay so as to provide one or some additional coat zones. Preferably, at least one pumping zone of each module of the coater comprises at least one source bay for a target material. This increases significantly the number of available positions for cathodes. The expression "modified pumping zone" means a pumping zone which comprises a source bay for a target material according to the invention.

In some cases, the existing pumping means associated with the modified pumping zone can be sufficient. At least one turbo-molecular pump is connected to the modified pumping zone. Advantageously, three turbo-molecular pumps are associated with the additional source bay added in the pumping zone. Those pumps may be affixed on the lid of the source (cathode) bay distributed along the width. This helps to maintain the required level of low pressure for sputtering process while additional gas for the sputtering atmosphere of the additional sputtering zone is introduced. The supplementary flows that will be added on the new sputtering position should more easily be evacuated by additional pumping capacity, either more pumps or pumps having a bigger pumping capacity, if the existing one has reached its limit.

Depending on the type of layer deposited within this additional coat zone, the sputtering atmosphere must be adapted for deposition of the required component. In some case it is necessary to inject a sputtering gas, such as argon, nitrogen, oxygen or other specific gas, to maintain the required partial pressure of this gas and/or the percentage of this gas necessary for the deposit. Preferably, said pumping zone comprises means for injecting gas. The most convenient injection system is a trim based system with five segments installed close to the sputtering source for deposition on, for example, a 3.21 m width glass substrate. However, other suitable means for injecting gas may be used.

The invention is especially concerned by modular coaters for the glass industry. Independently of the type of design, such coaters are generally broader than 2 m, for example 2.54 m (100 inches) broad, or preferably broader than 3 m, for example for jumbo size glass of 3,21 meters broad by about 6 m long the size of the coater may be about 4 meters broad.

The invention concerns also a method for increasing the performance of an existing modular vacuum coater having at least one module comprising at least one coat zone with at least one source bay for a target material and at least one pumping zone with pumping means, characterised in that at least one source bay for a target material is inserted into the pumping zone so as to use this pumping zone as an additional coat zone.

The invention allows increasing the number of coat zones so that efficiency of the coater is increased. It is surprising because the pumping zone of the coater is dedicated to maintain, thanks to the pumping means, the low pressure level required by the sputtering process in the adjacent coat zones, while the sputtering process requires a specific gas which may be introduced in the coat zone.

The pumping means originally associated with the pumping zone may be sufficient in some cases. At least one turbo-molecular pump is inserted in the pumping zone together with the source bay. Three turbo-molecular pumps may be attached along the length of the lid of the source bay through the width of the coater path for large flat glass substrates, typically 3.21 m wide and 6 m long. This allows maintaining the required low pressure level while using this pumping zone as a coat zone at a high rate of pulverisation.

This allows also depositing a complex coating, such as triple silver based solar control coating, in a relatively small existing coater.

The following figures are given for illustration purpose only, but they may not limit the scope of the present invention:
Figure 1 shows a module of a modular coater according to a first design type of the prior art;
Figure 2 shows the module of Figure 1 in which a source bay comprising a C-Mag® cathode has been inserted in the first pumping zone according to the invention;
Figure 3a shows a module of a coater according to a second design type of the prior art with the standard arrangement of sputtering and pumping compartments;
Figure 3b shows a module of a coater according to a second design type of the prior art with the mixed arrangement of sputtering and pumping compartments;
Figure 4a shows the module of figure 3a in which a source bay has been inserted in one pumping zone.
Figure 4b shows the module of figure 3b in which a source bay has been inserted in one pumping zone.
Figure 5 shows three turbo molecular pumps ("TMP") added in association with the added source bay of Figure 2; and
Figure 6 is a transverse section in Figure 5 and shows the trim gas injection system to trim the gas injection along the source bay.

Preferred embodiments are now described for illustration purpose on the basis of the annexed figures.

In the figures 1 and 2, SB0, SB1 ... mean Source Bay 0, Source Bay 1 ... DP means Diffusion Pump. IS1, IS2 ... mean Inter-Stage 1, Inter-Stage 2..., that is to say pumping zones for maintaining low pressure level in the coat zones. SB1, SB2 ... mean Source Bay 1, Source Bay 2 ... TMP means Turbo Molecular Pump.

The invention is limited to the use of turbo molecular pumps. According to non-inventive embodiments any pumping system for low level of gas pressure compatible with magnetron sputtering which can be associated with a source bay may be used.

A schematic overview of a module 1 of an existing modular coater of a first design type which can be found in the state of the art is shown in Figure 1. The module comprises one coat zone having three source bays SB1, SB2 and SB3 comprising each a dual C-MAG® rotatable cylindrical magnetron cathode 2. The module comprises also three "inter-stage" pumping zones IS1, IS2 and IS3. Each pumping zone is associated with pumping means formed here by several diffusion pumps DP. A typical total length of a standard isolation section formed by the three inter-stage pumping zones IS1, IS2 and IS3 is about 2 m.

According to the invention, a new source bay SB0 is added into the first inter-stage pumping zone IS1 as shown in Figure 2. This source bay comprises also a dual C-MAG® rotatable cylindrical magnetron cathode 3 like the other three source bays of the adjacent coat zone. Of course, other types of sputtering means than a dual rotatable cathode can be used. This provides an additional coat zone having a source bay within the site dedicated to the inter-stage pumping zone.

A schematic overview for a modular coater of a second design type (such as coater sold by Von Ardenne) is represented in two different arrangements in figures 3a and 3b. The roller conveyor for the glass sheet substrate on which the coating must be deposited is indicated by the reference number 10. In this design type, a module 11 comprises one pumping zone or pumping compartment 15 having turbo molecular pumps 14 and one coat zone or sputtering compartment 16 having a dual C-MAG® rotatable cylindrical magnetron cathode 12 schematized in the figures by two circles, supported by end blocks, on top of the bay.

The invention is described while referring in the figures to a roller conveyor for transporting the glass substrate. However, the invention applies also to coater having other transportation systems, such as an air cushion system in which a gas channel having holes therein in a direction of the flat glass substrate for maintaining the substrate in suspension on an air cushion. The invention applies also to coaters having sputter up cathodes for depositing a coating on the bottom of the substrate and also to vertical coaters in which the substrate moves in an almost vertical position.

In the figures, only three such modules are represented. However, it is obvious that more than three modules can be juxtaposed as needed to form the complete coater. In figure 3a, the three modules are juxtaposed in a standard arrangement one following the other. In figure 3b, the three modules are disposed in a so called "mixed arrangement" in which one pumping compartment is followed by two sputtering compartments and one pumping compartment, and then by one sputtering compartment and one pumping compartment, as shown in the figure. The sputtering compartments comprise each a dual C-MAG® rotatable cylindrical magnetron cathode 12.

According to the invention, a new coat zone or sputtering compartment 17 is formed by adding a dual C-MAG® rotatable cylindrical magnetron cathode 13 into the second pumping zone or compartment as shown on figure 4a and 4b. This provides an additional coat zone having a sputtering compartment within the site dedicated to the pumping zone.

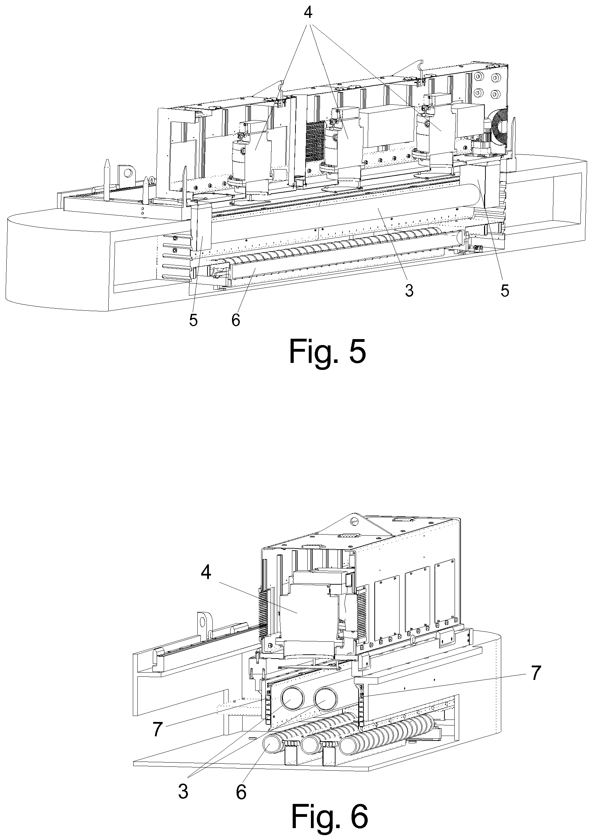

Figure 5 shows a transverse section through the first inter-stage pumping zone IS1 of the module 1 schematically represented in Figure 2 where a new source bay SBO is added. A special lid was built to fit with the dimensions of the inter-stage pumping zone and the end blocks for the cathodes were adapted to fit with the narrow space available in the pumping zone. Up to three source bays with cathode lids, not shown in the Figures, can fit into the available space between two coat zones in some existing coater. On Figure 5, the section is made between the two cylindrical tubes of the cathode 3, so that one of the two cylinders can be seen with part of the end blocks 5. The section within the three Turbo Molecular Pumps is shown at 4. The rollers of the conveyor can be seen at 6.

The cathode lid of the added dual rotatable cylindrical magnetron cathode 3 is drilled with holes for example DIN 320 or DIN 200 to fix pumps on top of it, as shown in Figure 5. Ideally three Turbo Molecular Pumps (TMP) 4 are used for a homogeneous pumping but one or two pumps may be enough.

In some circumstances, no extra pumping (other than exiting one on the line) is needed on the new lid. The skilled man knows that depending on the flows that are used in the surrounding sputtering areas, the process will be stable enough to use an extra sputtering position without extra pumping, especially when the original pumping capacity of the existing coater was over estimated or when free flanges are available next to the extra position or when bigger pumps can be added next to the new extra position. The basic idea here is that the supplementary flows that will be added on the new sputtering position should be evacuated either by existing pumping capacity or by additional pumping capacity if the existing one has reached its limit. Any type of pumps other than TMP (like for example diffusion pumps) at any place in the coater, which allow reaching a stable process pressure can be used.

Inside the coater, in the new sputtering coat zone, the existing and the new pumps can be protected by a plate or not. The size, shape and the position of that plate if any can have some influence on the pumping capacity and the uniformity of the deposited material on the glass. The reduction of the pumping capacity should be taken into account for the selection of the dimension of the pumps.

Figure 6 shows a longitudinal section, along the way of displacement of the sheet of glass on the conveyor, through the first inter-stage pumping zone IS1 of the module 1 schematically represented in Figure 2 where a new source bay SBO is added. This section is made through a Turbo Molecular pump 4. The dual added cathode is shown at 3, where both tubes are seen above the rollers 6 of the conveyor.

In case of magnetron sputtering as described in the Figures or PE-CVD or hollow cathode, an independent injection system for sputtering gas may be necessary. The most convenient injection system is a trim based system with five segments installed close to the sputtering source as shown at 7 in Figure 6. However the skilled man knows that gas supply can be common to several source bays and that it does not affect the stability of the process. He also knows that the position of the gas injection system and the number of segments mainly depends on the uniformity of the film that must be reached. So in any case a special injection system design inside or outside the sputtering chamber, on top or below the glass pass line may be considered in the scope of the present invention.

Depending on the power that is applied and dissipated on the new sputtering coat zone, cooling of the environment can be necessary. The dimension of the cooling circuit will be calculated to evacuate the power generated by the process. The design of the cooling depends on the geometry of the chamber and the space available, as known by the skilled man.

In the preferred embodiments described here above, only one pumping zone is provided with a source bay. However, it should be understood that several, even all, pumping zones can be provided with a source bay without departing with the invention.

## Claims

1. A modular vacuum coater having at least one module comprising at least one coat zone with at least one source bay for a target material and at least one pumping zone with pumping means, **characterized in that** the pumping zone comprises at least one source bay for a target material so as to use this pumping zone as an additional coat zone, and **in that** at least one turbo-molecular pump is connected to the pumping zone.

2. A modular vacuum coater according to claim 1, **characterized in that** at least one pumping zone of each module of the coater comprises at least one source bay for a target material.

3. A modular vacuum coater according to claim-g, **characterized in that** the turbo-molecular pump is fixed at the cathode lid of the source bay.

4. A modular vacuum coater according to any of the preceding claims, **characterized in that** said pumping zone comprises means for injecting gas.

5. A method for increasing the performance of an existing modular vacuum coater having at least one module comprising at least one coat zone with at least one source bay for a target material and at least one pumping zone with pumping means, **characterised in that** at least one source bay for a target material is inserted into the pumping zone so as to use this pumping zone as an additional coat zone, and **in that** at least one turbo-molecular pump is inserted in the pumping zone together with the source bay.

6. A method according to claim 5, **characterised in that** the pumping zone is evacuated using pumping means while target material is sputtered.

7. Use of the modified modular vacuum coater according to any of claims 1 to 4 to form a multilayered coating comprising at least three silver based layers on a glass substrate.

## Patentansprüche

1. Modularer Vakuumbeschichter, zumindest ein Modul aufweisend, das zumindest eine Beschichtungszone mit zumindest einem Quellfach für ein Zielmaterial und zumindest eine Pumpzone mit Pumpmitteln umfasst, **dadurch gekennzeichnet, dass** die Pumpzone zumindest ein Quellfach für ein Zielmaterial umfasst, um diese Pumpzone als eine zusätzliche Beschichtungszone zu verwenden, und dass zumindest eine Turbomolekularpumpe mit der Pumpzone verbunden ist.

2. Modularer Vakuumbeschichter nach Anspruch 1, **dadurch gekennzeichnet, dass** zumindest eine Pumpzone jedes Moduls des Beschichters zumindest ein Quellfach für ein Zielmaterial umfasst.

3. Modularer Vakuumbeschichter nach Anspruch 2, **dadurch gekennzeichnet, dass** die Turbomolekularpumpe am Kathodendeckel des Quellfachs befestigt ist.

4. Modularer Vakuumbeschichter nach einem der vorhergehenden Ansprüche, **dadurch gekennzeichnet, dass** die Pumpzone Mittel zum Einspeisen von Gas umfasst.

5. Verfahren zum Erhöhen der Leistung eines vorhandenen modularen Vakuumbeschichters, zumindest ein Modul aufweisend, das zumindest eine Beschichtungszone mit zumindest einem Quellfach für ein Zielmaterial und zumindest eine Pumpzone mit Pumpmitteln umfasst, **dadurch gekennzeichnet, dass** zumindest ein Quellfach für ein Zielmaterial in die Pumpzone eingesetzt ist, um diese Pumpzone als eine zusätzliche Beschichtungszone zu verwenden, und dass zumindest eine Turbomolekularpumpe in die Pumpzone zusammen mit dem Quellfach eingesetzt ist.

6. Verfahren nach Anspruch 5, **dadurch gekennzeichnet, dass** die Pumpzone unter Verwendung von Pumpmitteln evakuiert wird, während Zielmaterial aufgesprüht wird.

7. Verwenden des modifizierten modularen Vakuumbeschichters nach einem der Ansprüche 1 bis 4 zum Bilden einer mehrschichtigen Beschichtung, umfassend mindestens drei silberbasierte Schichten auf einem Glassubstrat.

## Revendications

1. Dispositif modulaire de revêtement sous vide présentant au moins un module comprenant au moins une zone de revêtement avec au moins un compartiment source pour un matériau cible et au moins une zone de pompage avec des moyens de pompage, **caractérisé en ce que** la zone de pompage comprend au moins un compartiment source pour un matériau cible de manière à utiliser cette zone de pompage en tant que zone de revêtement supplémentaire, et **en ce qu'**au moins une pompe turbomoléculaire est connectée à la zone de pompage.

2. Dispositif modulaire de revêtement sous vide selon la revendication 1, **caractérisé en ce qu'**au moins une zone de pompage de chaque module du dispositif de revêtement comprend au moins un compartiment source pour un matériau cible.

3. Dispositif modulaire de revêtement sous vide selon la revendication 2, **caractérisé en ce que** la pompe turbomoléculaire est fixée au couvercle de cathode du compartiment source.

4. Dispositif modulaire de revêtement sous vide selon l'une quelconque des revendications précédentes, **caractérisé en ce que** ladite zone de pompage comprend des moyens pour injecter du gaz.

5. Procédé pour augmenter la performance d'un dispositif modulaire de revêtement sous vide existant ayant au moins un module comprenant au moins une zone de revêtement avec au moins un compartiment source pour un matériau cible et au moins une zone de pompage avec des moyens de pompage, **caractérisé en ce qu'**au moins un compartiment source pour un matériau cible est inséré dans la zone de pompage de manière à utiliser cette zone de pompage en tant que zone de revêtement supplémentaire, et **en ce qu'**au moins une pompe turbomoléculaire est insérée dans la zone de pompage conjointement avec le compartiment source.

6. Procédé selon la revendication 5, **caractérisé en ce que** la zone de pompage est évacuée en utilisant des moyens de pompage tandis que du matériau cible est pulvérisé.

7. Utilisation du dispositif modulaire de revêtement sous vide modifié selon l'une quelconque des revendications 1 à 4 pour former un revêtement multicouche comprenant au moins trois couches à base d'argent sur un substrat en verre.
